## Europäisches Patentamt
## European Patent Office
## Office européen des brevets

(11) Veröffentlichungsnummer: **0 455 969 A1**

(12) **EUROPÄISCHE PATENTANMELDUNG**

(21) Anmeldenummer: 91104470.9

(51) Int. Cl.⁵: **H05K 7/20**

(22) Anmeldetag: 21.03.91

(30) Priorität: 10.05.90 DE 4015030

(43) Veröffentlichungstag der Anmeldung:
13.11.91 Patentblatt 91/46

(84) Benannte Vertragsstaaten:
AT DE FR GB

(71) Anmelder: **BICC-VERO ELECTRONICS GMBH**
**Carsten-Dressler-Strasse 10**
**W-2800 Bremen 61(DE)**

(72) Erfinder: **Weiss, Harald**
**Wörther Strasse 47**
**W-2800 Bremen 1(DE)**

(74) Vertreter: **Bohnenberger, Johannes, Dr. et al**
**Meissner, Bolte & Partner**
**Widenmayerstrasse 48**
**W-8000 München 22(DE)**

(54) **Sicherheitsnetzteil.**

(57) Es sind Netzteile, insbesondere primärgetaktete Netzteile bekannt, die ein geschlossenes Gehäuse sowie einen Primär- und einen Sekundärkreis mit entsprechenden, wärmeabgebenden Bauteilen aufweisen, wobei zur Kühlung der Bauteile zwangsbelüftete Kühleinrichtungen vorgesehen sind. Es wird ein Sicherheitsnetzteil vorgeschlagen, welches einen Lüftungskanal aufweist, der mit der Umgebungsluft als Kühlmedium in Strömungsverbindung steht. Die Kühleinrichtungen umfassen mindestens einen Kühlkörperabschnitt, der mittels Isoliereinrichtungen im Lüftungskanal elektrisch isoliert gehalten und zur Befestigung der wärmeabgebenden Bauteile ausgebildet ist.

EP 0 455 969 A1

Die Erfindung betrifft ein Sicherheitsnetzteil nach dem Oberbegriff des Patentanspruches 1, wobei es sich insbesondere um ein primärgetaktetes Netzteil handelt.

Primärgetaktete Netzteile finden aufgrund ihres hohen Wirkungsgrades und ihres geringen Bauvolumens in zunehmendem Maße Verwendung. Bei derartigen Netzteilen besteht nun das Problem, daß in vielen Fällen Sicherheitsanforderungen in verschiedener Hinsicht erfüllt werden müssen, wobei insbesondere die galvanische Trennung von Primär- und Sekundärkreis sowie die Berührungssicherheit eine wesentliche Rolle spielen. Letztere Forderung ist insbesondere dann schwierig zu erfüllen, wenn bei Netzteilen höherer Leistung größere Wärmemengen über Kühlkörper abzuführen sind, auf welchen Halbleiterbauteile montiert sind. Dies ist insbesondere dadurch bedingt, daß zur Erzielung eines optimalen Wärmeübergangs die Halbleiterbauteile direkt, also unisoliert am Kühlkörper montiert sein sollten, wodurch der Kühlkörper zwangsläufig auf das Potential des Halbleitergehäuses gelegt wird. Nach Möglichkeit sollte der Kühlkörper weiterhin mit der Umgebungsluft in freier Strömungsverbindung stehen, damit die Wärme möglichst gut abgeführt wird. Dies ist jedoch aufgrund der geforderten Berührungssicherheit im allgemeinen nicht möglich.

Der Erfindung liegt die Aufgabe zugrunde, ein Sicherheitsnetzteil der eingangs genannten Art aufzuzeigen, bei welchem eine gute Wärmeabführung unter gleichzeitiger Erfüllung hoher Sicherheitsanforderungen erzielbar ist.

Diese Aufgabe wird durch die im Kennzeichen des Patentanspruches 1 angegebenen Merkmale gelöst.

Ein wesentlicher Gedanke der Erfindung liegt darin, daß der Lüftungskanal selbst einen Berührungsschutz bildet.

Vorzugsweise ist der Lüftungskanal im Gehäuse verlaufend und von diesem dicht abgetrennt angeordnet, so daß das so ausgebildete Sicherheitsnetzteil auch in explosionsgefährdeten Räumen oder in Räumen hoher Luftfeuchtigkeit verwendbar ist.

Die Bauteileanzahl wird bei gleichzeitiger Verbesserung der Wärmeabführleistung dann besonders niedrig, wenn die Kühlkörperabschnitte selbst Teile des Lüftungskanals bilden. Derartige Kühlkörper sind an sich bekannt.

Die den Lüftungskanal bildenden Kühlkörperabschnitte für den Primär- und den Sekundärkreis sind hintereinander angeordnet, was in Anbetracht der Tatsache möglich ist, daß Primär- und Sekundärkreis im allgemeinen voneinander unterschiedliche Wärmemengen abgeben. Alternativ ist es möglich, die galvanisch voneinander getrennten Kühlkörperabschnitte als Teil-Umfangsabschnitte des einzigen Lüftungskanals auszubilden, wobei dann die Flächen der Kühlkörperabschnitte entsprechend den unterschiedlichen Wärmeabgabeleistungen gewählt werden.

Die Platzausnutzung wird dann besonders effektiv, wenn der Lüftungskanal das Gehäuse durchquerend ausgebildet ist. Hierbei kann entweder die Umgebungsluft auf der einen Gehäuseseite in den Lüftungskanal hinein und auf der anderen Seite wieder hinausströmen, oder aber die Ein- und die Auslaßöffnung für den Lüftungskanal sind an derselben Gehäusewand angeordnet. Im letzteren Fall wird vorzugsweise an der Auslaßöffnung eine Luftleitvorrichtung (Jalousie oder dergleichen) so angebracht, daß kein strömungsmäßiger Kurzschluß entstehen kann.

Zusätzlich zu den direkt auf den Kühlkörpern montierten Bauteilen entsteht im Gehäuse auch noch Wärme an weiteren aktiven und passiven Bauteilen. Vorzugsweise wird somit die Kühleinrichtung so ausgebildet, daß Wärme aus dem Innenraum des Gehäuses in den Luftkanal abführbar ist. Dazu werden Einrichtungen vorgesehen, welche die Luft im Innenraum des Gehäuses umwälzen. Dies kann durch eine entsprechende Anordnung der wärmeabführenden Bauteile innerhalb des Gehäuses und Luftleitvorrichtungen mit thermischer oder motorischer Umwälzung erfolgen.

Vorzugsweise umfassen die Kühleinrichtungen einen gesonderten Wärmetausch-Kühlkörper zum Abführen von Wärme aus dem Innenraum in den Lüftungskanal. Dadurch ist eine besonders niedrige Gehäuseinnentemperatur erzielbar.

Die Kühlkörperabschnitte bzw. den Wärmetausch-Kühlkörper fertigt man vorteilhafterweise als Strangpreßprofil, bei welchem die Kühlrippen in Luftstromrichtung verlaufen. Die Isoliereinrichtungen zum Isolieren der Kühlkörper voneinander und/oder der Kühlkörper vom Gehäuse werden vorzugsweise so ausgebildet, daß sie die gedruckten Schaltungen zum Aufbau der elektrischen Stromkreise tragen.

Die Sicherheit eines mit dicht zum Gehäuse angeordneten Lüftungskanal ausgestatteten Netzteils läßt sich dadurch weiter erhöhen, daß der Gehäuseinnenraum mit einem Inertgas (z.B. Stickstoff) gefüllt wird. Es läßt sich weiterhin ein Druckwächter im Netztteil installieren, der die Druckdifferenz zwischen Innenraum und Umgebung mißt und dann eine Inbetriebnahme des Netzteils verhindert und/oder ein Warnsignal erzeugt, wenn die Druckdifferenz zwischen Gehäuseinnenraum und Außenumgebung ein vorgegebenes Maß unterschreitet.

Weitere, für wesentlich erachtete Merkmale ergeben sich aus den Unteransprüchen und der nachfolgenden Beschreibung bevorzugter Ausführungsformen der Erfindung, die anhand von Abbildungen näher erläutert werden. Hierbei zeigen

Fig. 1

einen Teil-Horizontalschnitt durch eine erste Ausführungsform der Erfindung,

Fig. 2

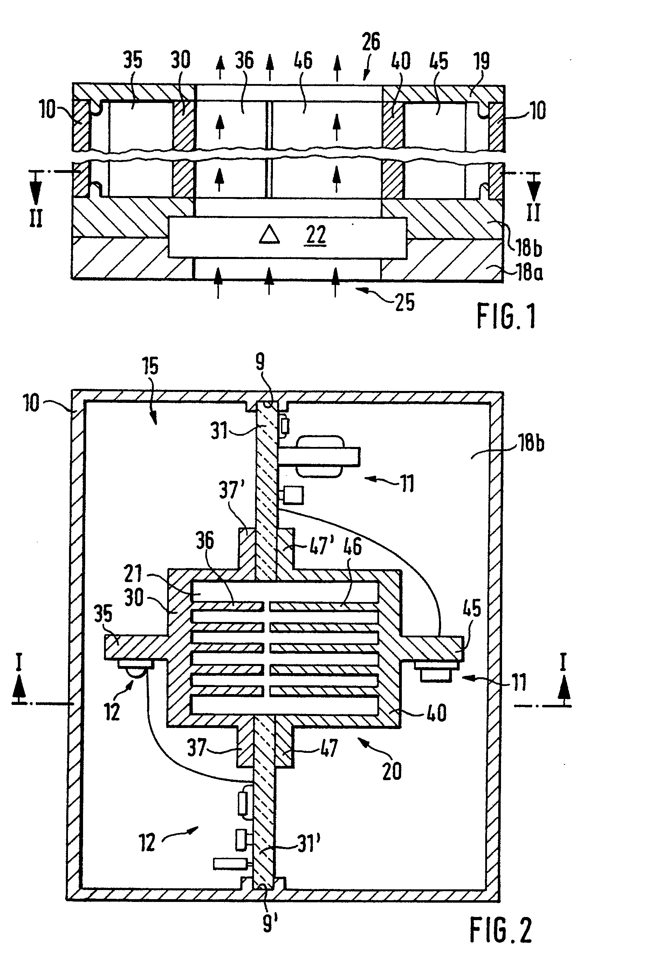

einen Schnitt entlang der Linie II-II aus Fig. 1,

Fig. 3

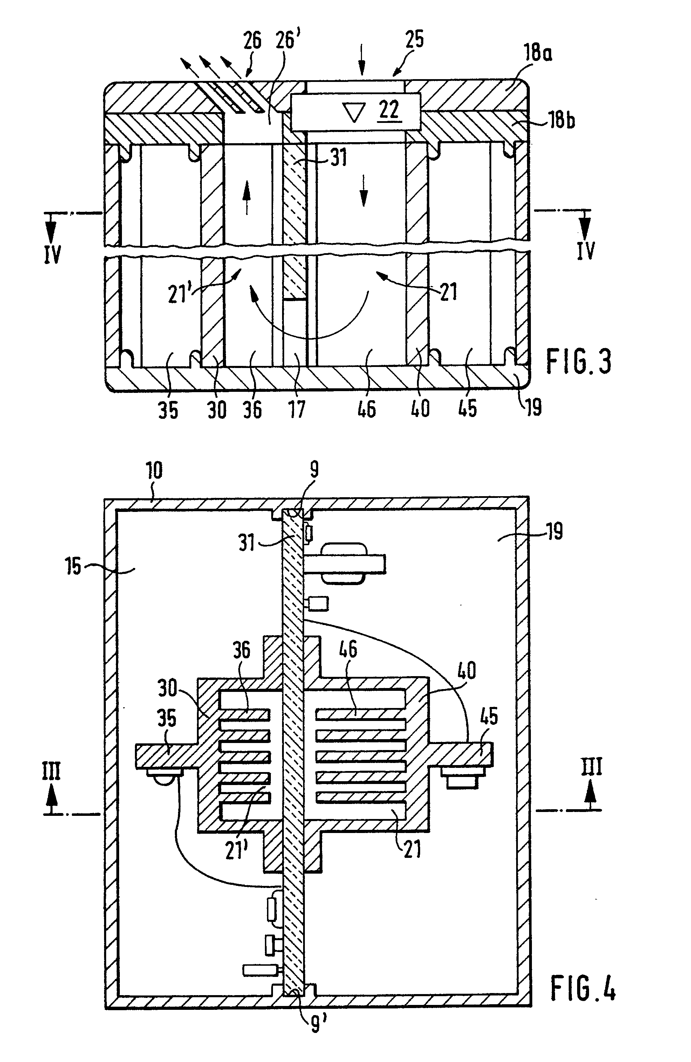

einen Schnitt ähnlich dem nach Fig. 1, jedoch durch eine zweite Ausführungsform der Erfindung,

Fig. 4

einen Schnitt entlang der Linie IV-IV aus Fig. 3,

Fig. 5

einen Teil-Schnitt durch einen Endbereich einer weiteren Ausführungsform der Erfindung in einer Ansicht ähnlich der nach Fig. 1,

Fig. 6 bis 8

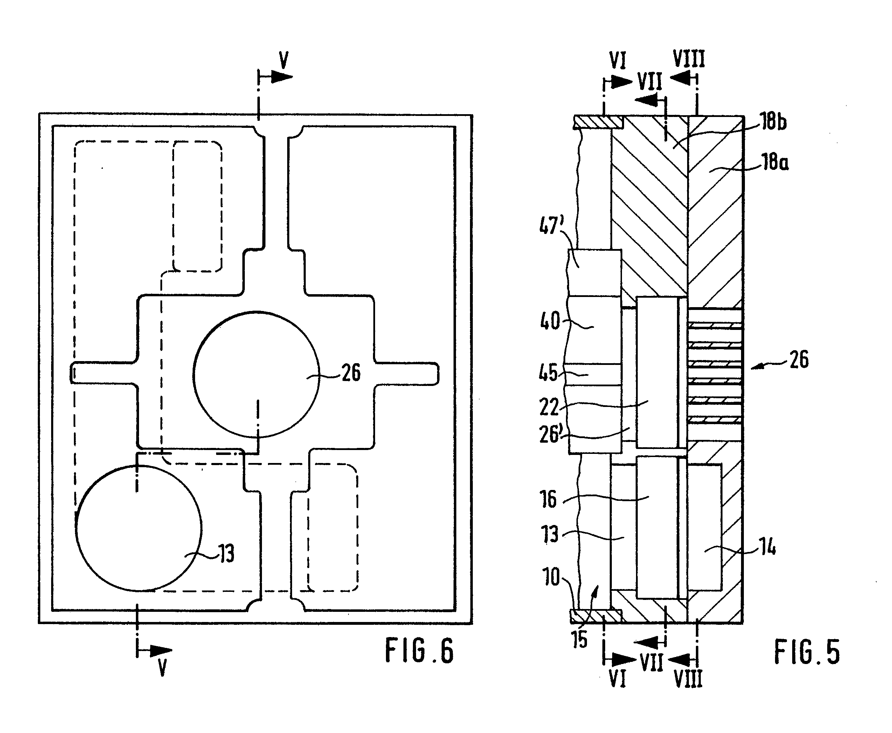

Schnitte entlang der Linien VI-IV bis VIII-VIII aus Fig. 5,

Fig. 9

einen Querschnitt ähnlich dem nach Fig. 2 durch eine weitere bevorzugte Ausführungsform der Erfindung,

Fig. 10 und 11

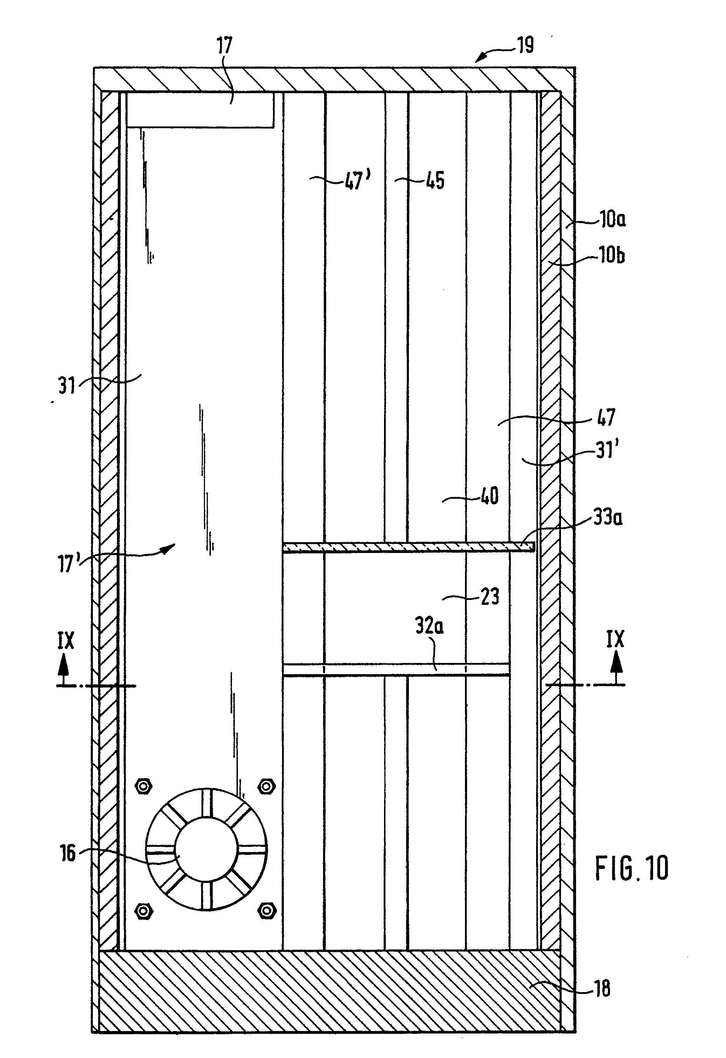

Schnitte entlang der Linien X-X bzw. XI-XI aus Fig. 9,

Fig. 12 und 13

Draufsichten auf Einzelbauteile der Ausführungsform nach den Fig. 9 bis 11,

Fig. 14

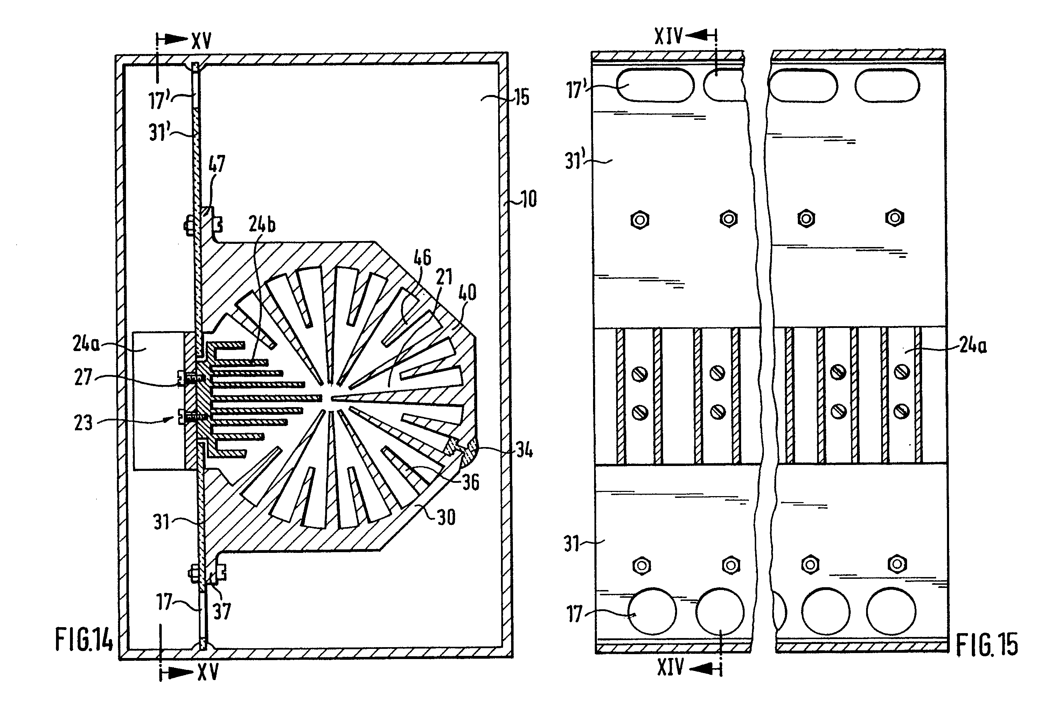

einen Querschnitt durch eine weitere Ausführungsform der Erfindung in einer Darstellung ähnlich der nach Fig. 2,

Fig. 15

einen Schnitt entlang der Linie XV-XV aus Fig. 14 und

Fig. 16

einen Querschnitt durch eine weitere Ausführungsform der Erfindung ähnlich der nach Fig. 14.

Bei einer weiteren Beschreibung werden für gleiche oder gleichartig wirkenden Teile dieselben Bezugsziffern verwendet.

Bei der ersten, in den Fig. 1 und 2 gezeigten Ausführungsform der Erfindung umfaßt das Sicherheitsnetzteil ein rohrförmiges Gehäuse 10, das an seinen Enden mit Endkappen 18a, 18b und 19 abgeschlossen ist (Fig. 1). Eine der Endkappen weist zwei Schalen 18a und 18b auf, zwischen denen ein Lüfter 22 gehalten ist, der Luft aus einer in der äußeren Schale 18a angebrachten Einlaßöffnung 25 ansaugen und durch eine in der inneren Schale 18b angebrachte entsprechende Öffnung in einen Lüftungskanal 21 blasen kann. Nach Durchquerung des Lüftungskanals 21 gelangt die Luft durch eine Auslaßöffnung 26 in der zweiten Endkappe 19 wieder ins Freie.

Der Lüftungskanal 21 wird durch zwei gemäß Fig. 2 ausgebildete Kühlkörperabschnitte 30 und 40 gebildet, die mit Befestigungsflanschen 37, 37' bzw. 47, 47' aufeinander entgegengesetzten Oberflächen von isolierenden Platinen 31, 31' befestigt sind. Das Profil der Kühlkörperabschnitte 30, 40 ist dergestalt, daß zwischen ihnen der Lüftungskanal 21 gebildet ist und gleichzeitig Kühlrippen 36, 46 der Kühlkörper 30, 40 in den Lüftungskanal 21 ragen.

Die Kühlkörper 30, 40 sind weiterhin mit Montageflanschen 35, 45 ausgestattet, auf welchen wärmeabgebende Bauteile 11 bzw. 12 des Primärkreises bzw. des Sekundärkreises befestigbar sind.

Die isolierenden Platinen 31, 31', auf welchen die Kühlkörper 30, 40 befestigt sind, sitzen mit ihren, den Kühlkörpern 30, 40 abgewandten Rändern in Haltenuten 9, 9', welche im Gehäuse 10 gebildet sind.

Die Endkappen 18a/b und 19 sind derart dicht mit dem Gehäuse 10 und den Kühlkörpern 30, 40 abschließend verbunden, daß der Innenraum 15 des Gehäuses 10 dicht gegenüber der Außenatmosphäre und weiterhin auch dicht gegenüber dem Lüftungskanal 21 ist.

Die Platinen 31, 31 halten zum einen die Kühleinrichtung 20 (gebildet aus den Kühlkörpern 30 und 40) in einer festen Position relativ zum Gehäuse 10, zum anderen teilt die Platine 31, 31' die Kühleinrichtung 20 in zwei voneinander elektrisch isolierte Kühlkörper, so daß die Bauteile 11 des Primärkreises elektrisch isoliert von den Bauteilen 12 des Sekundärkreises direkt auf den Kühlkörpern 30 bzw. 40 montierbar sind. Darüber hinaus dienen die Platinen 31, 31' gleichzeitig zur Aufnahme (gedruckte Schaltung) der übrigen, weniger wärmeabgebenden Bauteile.

Bei den in den Fig. 3 und 4 gezeigten Varianten der Erfindung ist eine, über die gesamte Höhe des Gehäuses 10 verlaufende einzige Platine vorgesehen, die somit den Lüftungskanal in einen ersten Abschnitt 21 und einen zweiten Abschnitt 21' teilt. Die beiden Abschnitte 21, 21' stehen über einen Luftdurchlaß in der Platine 31 in Verbindung, der an dem, der Einlaßöffnung 25 mit Lüfter 22 gegenüberliegenden Seite an der Platine angebracht ist. Die Endkappe 19 weist im Gegensatz zu der zuvor beschriebenen Ausführungsform keine Öffnung auf, während in der zweischaligen Endplatte 18a, 18b neben der Einlaßöffnung 25 eine Auslaßöffnung 26, 26' vorgesehen ist, die mit dem Kanalabschnitt 21' in Verbindung steht. Die Auslaßöffnung 26 ist mit Jalousien ausgestattet, um die erwärmte Kühlluft so ausströmen zu lassen, daß sie nicht wieder in die Einlaßöffnung 25 gesaugt wird. Im übrigen stimmt diese Ausführungsform mit der zuvor gezeigten Ausführungsform im wesentlichen überein.

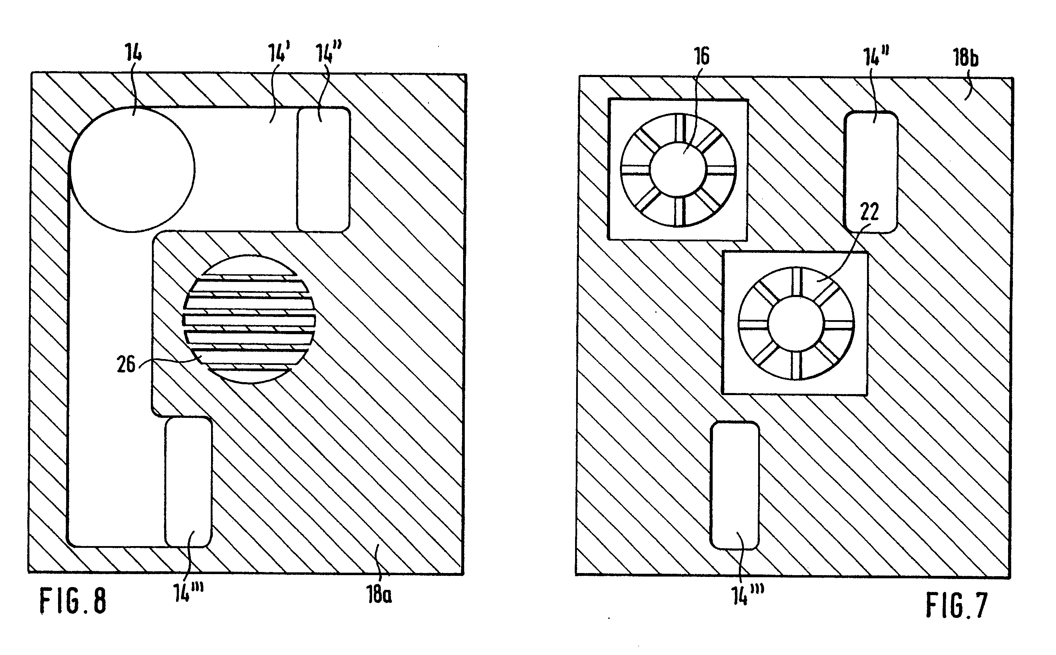

Bei der in den Fig. 5 bis 7 gezeigten Ausführungsform der Erfindung wird von einem Grundaufbau des Gehäuses 10, der Kühlkörper 30, 40 und der Platinen 31, 31' ausgegangen, wie er anhand der Fig. 2 erläutert wurde. Der wesentliche Unterschied der dritten Ausführungsform zur ersten Ausführungsform der Erfindung liegt in der unterschiedlichen Ausbildung der Endkappe, die neben dem bereits beschriebenen Lüfter 22 zur Erzeugung eines Luftstroms durch den Lüftungskanal 21 einen Lüfter 16 zur Umwälzung des Luftvolumens im Innenraum 15 des Gehäuses 10 aufweist. Der Lüfter 16 ist zwischen den beiden Schalen 18a und 18b gehalten und steht saugseitig über einen Innenlüftereinlaß 13 mit dem Gehäuseinnenraum 15 und druckseitig über Auslaßkanäle 14' in der äußeren Gehäuseschale 18a und Auslaßöffnungen 14", 14''' in der inneren Schale 18b mit anderen Stellen des Gehäuseinnenraums 15 in Verbindung. Die Platine 31' (siehe Fig. 2) weist an ihrem, der Endkappe 18a/b gegenüberliegenden Ende einen Durchbruch auf, so daß vom Gebläse 14 durch die Öffnung 14" geförderte Luft durch diesen Durchbruch hindurchtritt und wieder vom Gebläse 14 angesaugt werden kann. Die aus der Öffnung 14''' ausgeblasene Luft strömt durch den Spalt zwischen dem Montageflansch 35 und der Innenwand des Gehäuses (siehe Fig. 2) zur Einlaßöffnung 13 des Gebläses 14. Auf diese Weise wird die Luft im Innenraum 15 umgewälzt und kann durch die Außenflächen der Kühlkörper 30 und 40 gekühlt werden.

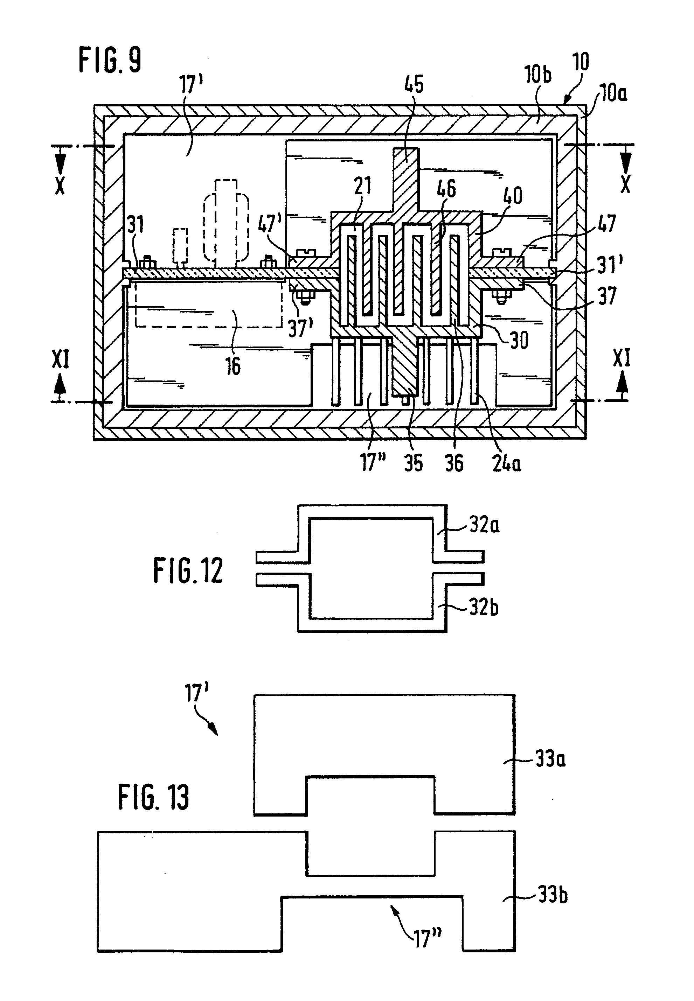

Im folgenden wird anhand der Fig. 9 - 13 eine weitere Ausführungform der Erfindung erläutert, wobei der Lüftungskanal 21 so wie bei der Ausführungsform nach den Fig. 1 und 2 das Gehäuse durchquert und in der Endkappe 28 ein Gebläse angeordnet ist, während in der mit dem Gehäuse 10 einstückig ausgebildeten Endwand 19 eine entsprechende Auslaßöffnung sitzt.

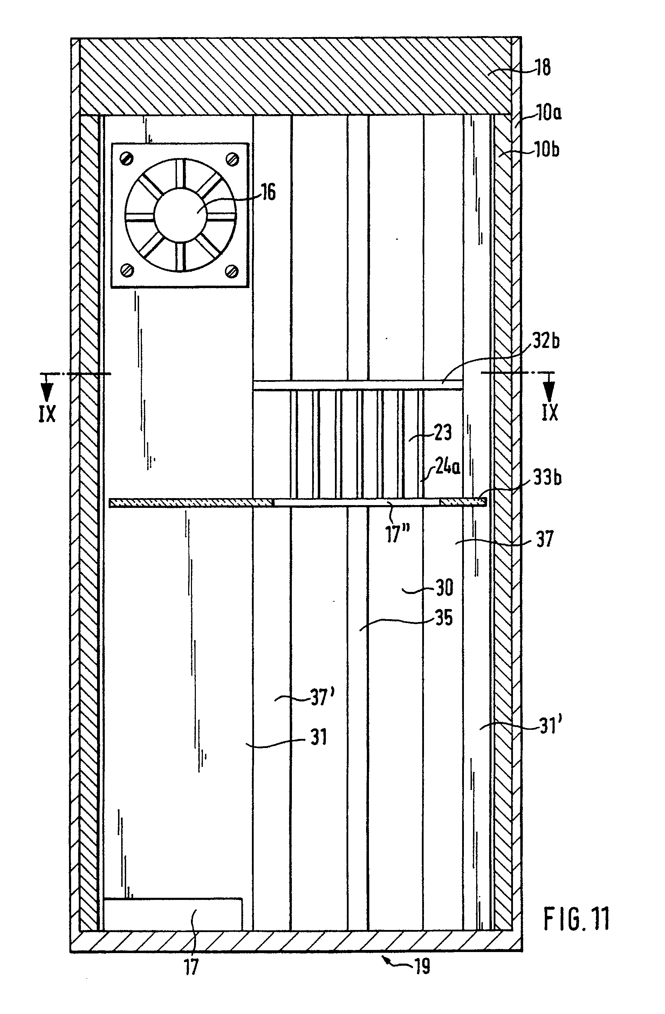

In einem weiteren Unterschied zur ersten Ausführungsform der Erfindung bilden die Kühlkörper 30, 40 nur einen geringeren Längen-Teil des Kanals 21. Ein weiterer Längenabschnitt des Kanals 21 wird von einem weiteren Kühlkörper 23 gebildet, der zu den Kühlkörpern 30, 40 über Isolierplatten 33a und 33b elektrisch getrennt, aber strömungsmäßig dicht abschlossen ist. In den Fig. 10 und 11 ist eine Ausführungsform gezeigt, bei welcher ein anderer Kühlkörper über Isolierplatten 32a, 32b an den Kühlkörper 23 anschließt und so die Gesamtlänge des Lüftungskanals 21 vollendet.

Der Kühlkörper 23 weist in den Gehäuseinnenraum 15 ragende Kühlrippen 24 auf, so daß er als Wärmetauscher zwischen dem Gehäuseinnenraum 15 und dem Lüftungskanal 21 dient.

Um die Luft im Gehäuseinneraum umzuwälzen, ist in der Platine 31 am einen Ende, nahe der Endkappe 18 ein Lüfter 16 angebracht, während an ihrem anderen Ende, nahe der Endwand 19 ein Luftdurchlaß 17 vorgesehen ist.

Die eine Isolierplatte 33b, welche den Wärmetausch-Kühlkörper 23 vom Kühlkörper 30 elektrisch trennt, weist im Bereich der Kühlrippen 24a des Kühlkörpers 23 eine Öffnung 17" auf. Die andere Isolierplatte 33a, welche den Wärmetausch-Kühlkörper 23 vom Kühlkörper 40 trennt, ist nur über die Gesamtbreite des Kühlkörpers 40 ausgebildet, so daß über der Platine 31 ein Luftdurchlaß 17' entsteht.

Bei der so gezeigten Anordnung wird vom Innenraumlüfter 16 ausgeblasene Luft durch den Gehäuseinnenraum (in Fig. 11 von oben nach unten) unter Vorbeistreichen an den elektrischen Bauteilen und Durchqueren der Öffnung 17' gefördert, tritt durch den Luftdurchlaß 17 hindurch und strömt auf der anderen Seite der Platine 31 durch die Öffnung 17" an den Kühlrippen 24a des Wärmetausch-Kühlkörpers 23 vorbei, wird dort gekühlt und wird wieder vom Lüfter 16 angesaugt.

Im folgenden wird eine weitere Ausführungsform der Erfindung anhand der Fig. 14 und 15 erläutert.

Bei dieser Ausführungsform der Erfindung umschreiben die Kühlkörper 30 und 40 einen Lüftungskanal 21 mit im wesentlichen kreisförmigem Querschnitt, in welchen die Kühlrippen 36 und 46 der Kühlkörper 30 und 40 radial ragen. Die Kühlkörper 30 und 40 sind über ein Isolierstück 34 mechanisch fest (und dicht) verbunden, jedoch elektrisch voneinander getrennt. Die Kühlkörper 30 und 40 sind mit ihren Befestigungsflanschen 37 und 47 auf Platinen 31, 31' befestigt. Die Platinen 31, 31' ragen über die Kühlkörper 30, 40 aufeinander zugerichtet vor und bilden zwischeneinander einen Spalt. In dem Spalt ist der Wärmetausch-Körper zur Kühlung des Innenraums befestigt und bestehen aus einem Lüftungskanal-inneren Teil mit in Längsrichtung zum Lüftungskanal 21 verlaufenden Kühlrippen 24b und einem fest darauf durch Schrauben 27 montierten äußeren Teil mit Kühlrippen 24a, die senkrecht zu den inneren Kühlrippen 24b verlaufen.

In den Platinen 31, 31' sind Luftdurchlässe 17, 17' vorgesehen.

Bei der so ausgebildeten Variante kommt es bei einer Aufstellungsart gemäß der Fig. 14, 15 zu einer thermischen Luftumwälzung, da auf den Wärmetausch-Kühlkörper keine wärmeabgebenden Bauteile montiert sind und die Kühlrippe 24a somit kälter als die Kühlkörper 30, 40 ist. Es strömt somit an den Kühlrippen 24a abgekühlte Luft nach unten, durch die Öffnungen 17 in den Innenraum 15 des Gehäuses 10, im Spalt zwischen dem Gehäuse 10 und dem Kühlkörper 40 nach oben und tritt durch die Luftdurchlässe 17 wieder in den Raum hinter der Platine 31' ein.

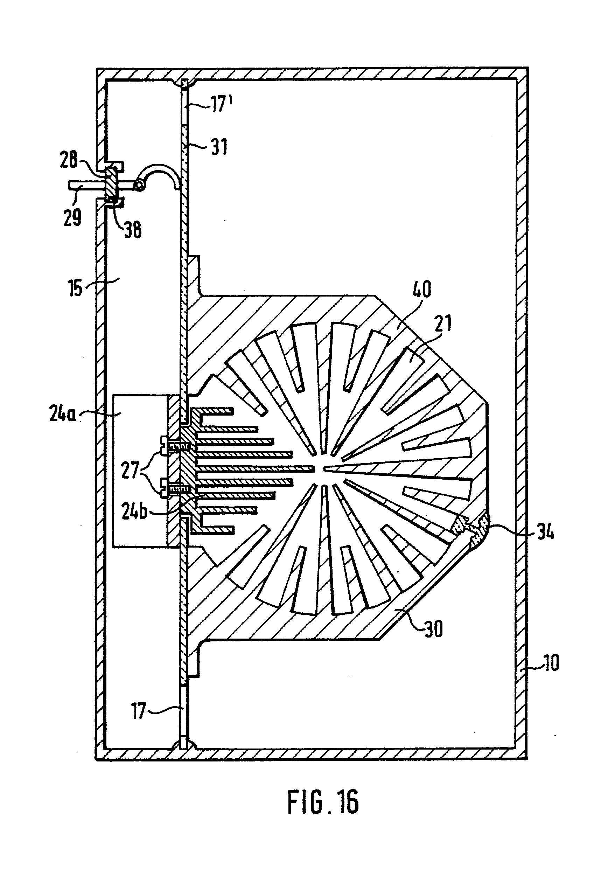

Bei der in Fig. 16 gezeigten Abwandlung der Ausführungsform nach den Fig. 14 und 15 ist an einer Wand des Gehäuses 10 eine Gehäusenut 38 vorgesehen, in welcher eine Stromschiene 28 montiert ist, deren Kontakte 29 aus dem Gehäuse 10 hervorstehen und im Gehäuseinneren 15 mit der Platine 31 bzw. dort vorgesehenen Leiterbahnen verbunden sind.

Die in der vorangegangenen Beschreibung erläuterten Kühlkörper 30, 40 und 23 sind ebenso wie das Gehäuse 10 vorzugsweise aus Aluminium-Strangpreßmaterial gefertigt. Das Gehäuse 10 kann, wie bei der Ausführungsform nach den Fig. 9 bis 11 gezeigt, auch zweischalig ausgebildet sein, um einerseits eine Störstrahlungsabschirmung (von innen nach außen wie auch umgekehrt) durch Verwendung entsprechend leitenden Materials, andererseits eine elektrische Isolierung gegenüber Berührung andererseits zu erzielen.

Bezugszeichenliste

| | |
|---|---|
| 9 | Haltenut |
| 10 | Gehäuse |
| 11 | Bauteile-Primärkreis |
| 12 | Bauteile-Sekundärkreis |
| 13 | Innenlüftereinlaß |
| 14 | Innenlüfterauslaß |
| 15 | Innenraum |
| 16 | Lüfter |
| 17 | Luftdurchlaß |
| 18 | Endkappe |
| 19 | Endkappe |
| 20 | Kühleinrichtung |
| 21 | Lüftungskanal |
| 22 | Lüfter |
| 23 | Wärmetauscher-Kühlkörper |
| 24 | Kühlrippen |
| 25 | Einlaßöffnung |
| 26 | Auslaßöffnung |
| 27 | Schrauben |
| 28 | Stromschiene |
| 29 | Kontakt |
| 30 | Primär-Kühlkörperabschnitt |
| 31 | Platine |
| 32-34 | Isoliereinrichtungen |
| 35 | Montageflansch |
| 36 | Kühlrippen |
| 37 | Befestigungsflansch |
| 38 | Gehäusenut |
| 40 | Sekundär-Kühlkörperabschnitt |
| 45 | Montageflansch |
| 46 | Kühlrippen |
| 47 | Befestigungsflansch |

**Patentansprüche**

1.  Sicherheitsnetzteil, insbesondere primärgetaktetes Netzteil mit einem geschlossenen Gehäuse (10), einem Primärkreis mit wärmeabgebenden Bauteilen (11), einem Sekundärkreis mit wärmeabgebenden Bauteilen (12) und mit zwangsbelüfteten (Lüfter 22) Kühleinrichtungen (20) **dadurch gekennzeichnet,** daß ein Lüftungskanal (21) vorgesehen ist, der mit der Umgebungsluft als Kühlmedium in Strömungsverbindung steht und daß die Kühleinrichtungen (20) mindestens einen Kühlkörperabschnitt (30, 40) umfassen, der mittels Isoliereinrichtungen (18, 19, 31 - 34) im Lüftungskanal (21) elektrisch isoliert sowie von außen unzugänglich gehalten und zur Befestigung der Wärme abgebenden Bauteile (11, 12) ausgebildet ist.

2.  Sicherheitsnetzteil nach Anspruch 1, dadurch gekennzeichnet, daß der Lüftungskanal (21) im Gehäuse (10) verlaufend und von diesem dicht abgetrennt angeordnet ist.

3.  Sicherheitsnetzteil nach einem der vorhergehenden Ansprüche, dadurch gekennzeichnet, daß die Kühleinrichtungen (20) zwei voneinander elektrisch getrennte Kühlkörperabschnitte (30, 40) umfassen, die zur getrennten Befestigung der wärmeabgebenden Bauteile (11, 12) des Primär- und des Sekundärkreises ausgebildet sind.

4.  Sicherheitsnetzteil nach einem der vorhergehenden Ansprüche, dadurch gekennzeichnet, daß der (die) Kühlkörperabschnitt(e) (30, 40) den Lüftungskanal (21) definierend ausgebildet ist (sind).

5.  Sicherheitsnetzteil nach einem der Ansprüche 3 oder 4, dadurch gekennzeichnet, daß die Kühlkörperabschnitte (30, 40) in den Lüftungskanal (21) ragend in Strömungsrichtung gesehen hintereinander angeordnet sind.

6.  Sicherheitsnetzteil nach einem der Ansprüche 3 bis 5, daß die Kühlkörperabschnitte (30, 40) Teilumfangsabschnitte des Lüftungskanals (21) definierend ausgebildet sind.

7.  Sicherheitsnetzteil nach einem der vorhergehenden Ansprüche, dadurch gekennzeichnet, daß der Lüftungskanal (21) das Gehäuse (10) durchquerend ausgebildet ist.

8.  Sicherheitsnetzteil nach Anspruch 7, dadurch gekennzeichnet, daß der Lüftungskanal (21) derart zweigeteilt ausgebildet ist, daß eine Einlaßöffnung (25) und eine Auslaßöffnung (26) des Lüftungskanals (21) an derselben Wand (18) des Gehäuses (10) liegen.

9. Sicherheitsnetzteil nach einem der vorhergehenden Ansprüche, dadurch gekennzeichnet, daß die Kühleinrichtung (20) derart ausgebildet ist, daß Wärme aus dem Innenraum (15) des Gehäuses (10) in den Lüftungskanal (21) abführbar ist.

10. Sicherheitsnetzteil nach Anspruch 9, dadurch gekennzeichnet, daß die Luft des Innenraums (15) umwälzende Einrichtungen (16, 17) vorgesehen sind.

11. Sicherheitsnetzteil nach einem der Ansprüche 9 oder 10, dadurch gekennzeichnet, daß die Kühleinrichtung (20) einen gesonderten Wärmetausch-Kühlkörper (23) zur Abführung von Wärme aus dem Innenraum (15) in den Lüftungskanal (21) aufweist.

12. Sicherheitsnetzteil nach einem der vorhergehenden Ansprüche, dadurch gekennzeichnet, daß die Kühlkörperabschnitte (30, 40) und/oder der Wärmetausch-Kühlkörper (23) und/oder das Gehäuse (10) als Strangpreßprofile ausgebildet sind.

13. Sicherheitsnetzteil nach einem der vorhergehenden Ansprüche, dadurch gekennzeichnet, daß mindestens eine der Isoliereinrichtungen (31, 31') als gedruckte Schaltungsplatine zum Aufbau des Primär- und/oder des Sekundärschaltkreises aufgebaut ist.

14. Sicherheitsnetzteil nach einem der vorhergehenden Ansprüche, dadurch gekennzeichnet, daß der Gehäuseinnenraum (15) mit einer Schutzgasfüllung befüllt ist.

FIG.1

FIG.2

FIG.3

FIG.4

FIG.5

FIG.6

FIG.7

FIG.8

FIG.10

FIG.11

FIG.9

FIG.12

FIG.13

FIG.14

FIG.15

EP 0 455 969 A1

FIG.16

Europäisches
Patentamt

**EUROPÄISCHER
RECHERCHENBERICHT**

Nummer der Anmeldung

**EP 91 10 4470**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | DE-A-2 710 432   (DANFOSS A/S) <br> * Anspruch 1; Seite 11, Zeilen 11-14; Figur 1 * <br> - - - | 1-4,7 | H 05 K 7/20 |
| Y | DE-A-3 710 198   (ZENTRO-ELEKTRIK GmbH KG) <br> * Spalte 2, Zeilen 48-51; Spalte 4, Zeilen 40,44-45; Spalte 5, Zeilen 64-68; Spalte 6, Zeilen 12-16; Figuren 1,2 * <br> - - - | 1-4,7 | |
| A | FR-A-2 606 581   (BICC-VERO) <br> * Seite 19, Zeilen 8-25; Figuren 22,23 * <br> - - - - - | 1-2 | |

|  | RECHERCHIERTE SACHGEBIETE (Int. Cl.5) |
|---|---|
|  | H 05 K |

Der vorliegende Recherchenbericht wurde für alle Patentansprüche erstellt

| Recherchenort | Abschlußdatum der Recherche | Prüfer |
|---|---|---|
| Den Haag | 09 August 91 | RUBENOWITZ A.S. |